# EUROPEAN PATENT SPECIFICATION

(11) **EP 1 850 375 B1**
(45) Date of publication and mention of the grant of the patent: **30.11.2011**
(21) Application number: 06713838.8
(22) Date of filing: 16.02.2006
(51) Int. Cl.: H01L 21/683, H01L 21/68, C09J 7/02

(54) **SEMICONDUCTOR WAFER SURFACE PROTECTING SHEET AND SEMICONDUCTOR WAFER PROTECTING METHOD USING SUCH PROTECTING SHEET**
HALBLEITERWAFEROBERFLÄCHENSCHUTZFILM UND HALBLEITERWAFERSCHUTZVERFAHREN MIT EINEM SOLCHEN SCHUTZFILM
FEUILLE DE PROTECTION DE LA SURFACE D'UNE TRANCHE A SEMI-CONDUCTEUR ET PROCEDE DE PROTECTION DE TRANCHE A SEMI-CONDUCTEUR EMPLOYANT LADITE FEUILLE

(30) Priority: 18.02.2005 JP 2005042115
(43) Date of publication of application: 31.10.2007
(73) Proprietor: Mitsui Chemicals, Inc., Tokyo 105-7117 (JP)
(72) Inventor: SAIMOTO, Yoshihisa c/o Mitsui Chemicals, Inc.,, Tokyo, 105-7117 (JP); URAKAWA, Toshiya c/o Mitsui Chemicals, Inc.,, Nagoya-shi, Aichi, 457-8522 (JP); NAKAJIMA, Akemi c/o Mitsui Chemicals, Inc.,, Nagoya-shi, Aichi, 457-8522 (JP); AKAI, Ikuo c/o Mitsui Chemicals Fabro, Inc.,, Nagoya-shi, Aichi, 457-8522 (JP); AIHARA, Shin c/o Mitsui Chemicals Fabro, Inc.,, Aichi, 457-8522 (JP)
(74) Representative: HOFFMANN EITLE
(86) International application number: PCT/JP2006/302697
(87) International publication number: WO 2006/088074

(56) References cited:
- JP-A- 2002 069 396
- JP-A- 2002 201 442
- JP-A- 2004 006 630
- JP-A- 2004 259 713
- US-A1- 2003 064 579

## Description

### TECHNICAL FIELD

The present invention relates to a semiconductor wafer surface protection sheet and a method for protecting a semiconductor wafer using such a protection sheet. More particularly, the invention relates to a semiconductor wafer surface protection sheet and a method for protecting a semiconductor wafer using such protection sheet which are useful in preventing the breakage of a semiconductor wafer during and after grinding the non-circuit-formed surface of the semiconductor wafer and can enhance the productivity in processing a non-circuit-formed surface of the semiconductor wafer.

### BACKGROUND ART

Processing a semiconductor wafer includes a step of adhering a semiconductor wafer surface protection sheet to a circuit-formed surface of the semiconductor wafer (hereinafter, a semiconductor wafer surface), a step of processing a non-circuit-formed surface of the semiconductor wafer (hereinafter, a semiconductor wafer back surface), a step of peeling the surface protection sheet for the semiconductor wafer, a step of dicing for dividing and cutting the semiconductor wafer into chips, a step of die bonding for bonding the divided semiconductor chip to a lead frame, then a step of molding for sealing the semiconductor chip with a resin for protecting the outer portion, and the like. As a conventional semiconductor wafer surface protection sheet, an adhesive film coated with an adhesive layer on one surface of a resin film is the mainstream and has been used in the production process of semiconductor wafers. The main characteristics required for the semiconductor wafer protecting adhesive film include absorbing grinding stress (prevention of the breakage of a semiconductor wafer) during mechanically grinding the semiconductor wafer back surface after attaching the adhesive film, being able to be peeled off with an optimum force (prevention of the breakage of the ground semiconductor wafer), preventing from leaving transferred substance on the semiconductor wafer surface after peeling the adhesive film, and so forth. Such a semiconductor wafer surface protecting adhesive film is disclosed in Japanese Patent Application Laid-Open (JP-A) Nos. 61-10242, 61-043677, 62-271451 and the like.

Reference is also made to prior art documents JP-A-2004 259713, JP-A-2004 006630 and US-A1-2003 064579.

On a semiconductor wafer surface, there are a polyimide film, aluminum electrodes, scribe lines for dicing and the like. The shape of the surface is uneven, filled with ups and downs. Unless such unevenness is fully absorbed by the adhesive film, problems occur such as the semiconductor wafer breaking due to the grinding stress during a grinding process. There has been proposed an adhesive film with enhanced adhesion coated with an ultraviolet curing adhesive as a measure against such an uneven shape on the semiconductor wafer surface. The ultraviolet curing adhesive film is capable of suppressing the crosslinking density of an adhesive at a small level and an elastic modulus thereof at an extremely low level at the time of attaching, grinding or the like, exhibits high adhesion on the semiconductor wafer surface, and promotes the curing reaction by an irradiation with ultraviolet light at the time of peeling, thus resulting in increasing the crosslinking density. The adhesive film can be regarded as a functional tape that has a high elastic modulus and is able to be easily peeled off from the wafer. However, a problem has been pointed out that a resin of an adhesive remains on the semiconductor wafer surface since the semiconductor wafer is cured while the adhesive is tightly adhered to the uneven surface.

On the other hand, with recent developments in high-density mounting technology, production processing of a semiconductor wafer has also greatly changed. Firstly, in order to realize high-functional and miniaturized devices with a high-density mounting chip design, the multilayer mounting technology of semiconductor chips is under development. With the multilayer mounting technology, the finished silicon thickness after grinding is targeted at 100 µm or less, with the number of laminated chips of 2 to 10 layers. With high-density mounting design, a thick portion which was not problematic in the past is now considered to better be thinned as well. Specifically, a semiconductor wafer with solder bumps formed thereon for connecting chips and a circuit substrate as an electrode in a spherical pattern can be cited. In the past, a semiconductor wafer with solder bumps formed thereon was not supposed to be thinned very much -- about 400 m to 600 um -- even a grinding processing is involved.

However, in recent years, even for a semiconductor wafer with solder bumps formed thereon, a step of finishing the silicon part to 400 µm or less with a grinding process is under development. In this case, the strength of the semiconductor wafer which is finished to the thickness of 400 µm or less with a grinding process is reduced. It has been pointed out that when such a semiconductor wafer passes through a step of forming solder bumps, a problem occurs whereby the semiconductor wafer breaks due to the load caused by the formation of solder bumps. As a result, it has become a popular process to form solder bumps in advance prior to grinding the semiconductor wafer while the wafer has some strength.

A semiconductor wafer surface protecting adhesive film that does not sufficiently absorb the unevenness of the solder bumps would cause voids at the circumference of the solder bumps as a result of insufficient adhesion between the film and the solder bumps. Accordingly, stress is unevenly distributed on the semiconductor wafer surface during a grinding process, thereby causing breakage of the semiconductor wafer. The solder bumps may be spherical or in a shape similar to a trapezoid, different from device to device, and from design to design by manufacturer, but the semiconductor wafers with solder bumps disposed thereon generally have unevenness of very high step difference disposed on a pattern, the uneven gap being much larger than that of conventional semiconductor wafers having unevenness of 20 µm to 200 µm. Furthermore, in recent years, due to technical considerations, a technology called wafer-level package has come into wide use to further reduce the mounting size. This is a process that includes, after the completion of semiconductor wafer processes (the front-end processing), forming a metal film, rewiring, forming a metal post, sealing with a resin at a wafer state, and then forming solder bumps. The size of the package is reduced to about 25% of the conventional package, and it is suggested that this package may become a core mounting technology in the future.

This wafer-level package technology also includes a process for finishing the silicon part by grinding. It is considered reasonable in this technology to first form solder bumps, and then to grind the silicon part so as to finish the silicon part as thin as with the conventional solder bump technology. In wafer-level package technology, the height of the solder bump is supposedly as high as 250 µm or 500 µm. Thus, there has been a need for a surface protection sheet suitable for processing the semiconductor wafer having much higher uneven step difference and a method for protecting the semiconductor wafer using the protection sheet. Furthermore, the surface shape of the semiconductor wafer has become complicated in that a scribe line on the semiconductor wafer surface has become deeper or finer, even the circumference of the semiconductor wafer is designed, or the thickness of a polyimide film is changed, the shape of an aluminum pad is changed, and a gold bump of 20 µm to 50 µm is formed on a semiconductor wafer for liquid crystal driver or the like. Thus, there has been a need for a semiconductor wafer surface protection sheet and a method for protecting the semiconductor wafer using such protection sheet.

### DISCLOSURE OF THE INVENTION

The present invention according to claims 1 and 11 has been made in view of the above circumstances, and provides a semiconductor wafer surface protection sheet and a method for protecting a semiconductor wafer using the protection sheet which can prevent the breakage of a semiconductor wafer even when the finished thickness of a silicon part is thinned by grinding when processing a semiconductor wafer having an uneven surface with extremely big step difference such as solder bumps.

The present inventors have conducted an extensive study and, as a result, have found that a semiconductor wafer surface protection sheet comprising a resin layer (A) satisfying the relationship of G' (60) / G' (25) < 0.1 can solve the above-identified problems where a storage elastic modulus at 25°C is represented by G' (25) and a storage elastic modulus at 60°C is represented by G' (60). Accordingly, the present invention has been completed.

A first aspect of the invention provides a semiconductor wafer surface protection sheet comprising at least a resin layer (A) satisfying the relationship of G' (60) / G' (25) < 0.1 where G' (25) represents a storage elastic modulus at 25°C, and G' (60) represents a storage elastic modulus at 60°C.

A density of the resin layer (A) of from 800 kg/m³ to 890 kg/m³ is a preferred embodiment from the viewpoint that an elastic modulus can be managed in heating the resin layer (A). The resin layer (A) comprising an olefin copolymer is a preferred embodiment from the viewpoint that a cohesive force between polymer chains is maintained.

A second aspect of the invention provides a method for protecting a semiconductor wafer comprising a first step of adhering the semiconductor wafer surface protection sheet of the first aspect to the surface of a semiconductor wafer while pressurizing at a pressure range of 0.3 MPa to 0.5 MPa and at a temperature range of 40°C to 70°C, a second step of grinding the semiconductor wafer back surface, and a third step of processing the semiconductor wafer back surface after grinding.

A semiconductor wafer surface protection sheet of the present invention in which an elastic modulus of the resin and, as needed, a density are controlled can be a member suitable in a series of steps for protecting a semiconductor wafer having extremely high unevenness so that the breakage of a semiconductor wafer, contamination or the like can be prevented.

Furthermore, according to the method of the present invention, even in a grinding step of a semiconductor wafer having extremely high unevenness on the surface, it is possible to prevent the breakage of a semiconductor wafer in a series of the above steps.

### BEST MODE FOR CARRYING OUT THE INVENTION

The present invention will be described in more detail below.

The semiconductor wafer surface protection sheet of the present invention comprises at least one layer of a resin layer (A) satisfying the relationship of G' (60) / G' (25) < 0.1 where G' (25) represents a storage elastic modulus at 25°C, and G' (60) represents a storage elastic modulus at 60°C When the storage elastic modulus is within the above range, it is possible to obtain an effect of high adhesion to the unevenness on the surface of the wafer. The range is more preferably G' (60) / G' (25) < 0.08 and particularly preferably G' (60) / G' (25) < 0.05.

The storage elastic modulus G' (60) is from 0.05 x 10⁶ Pa to 1.0 x 10⁶ Pa and more preferably from 0.075 x 10⁶ Pa to 0.5 X 10⁶ Pa. The storage elastic modulus G' (25) is preferably from 4.0 x 10⁶ Pa to 7.0 x 10⁶ Pa and more preferably from 4.5 x 10⁶ Pa to 6.5 x 10⁶ Pa. By designing a resin to have such a storage elastic modulus range, at the time of attaching the sheet, an elastic modulus of the resin layer can be controlled by heating for exhibiting Bingham fluid behavior and for enhancing adhesion on the uneven wafer surface. Furthermore, after the sheet is attached, the shape of the resin layer is maintained so that adhesion can be maintained during processing.

The density of the resin layer (A) is preferably from 800 kg/m³ to 890 kg/m³, more preferably from 830 kg/m³ to 890 kg/m³ and particularly preferably from 850 kg/m³ to 890 kg/m³. By virtue of the density within the above range, it is possible to exhibit effects such that the elastic modulus can be controlled while heating for attaching the resin layer (A), and a cohesive force of the resin layer can be controlled in peeling off the sheet from the semiconductor wafer (reduced resin residue on the semiconductor wafer surface).

The sheet according to the present invention can be prepared by laminating, on a base film, the resin layer (A) formed by a film-making process according to a known molding method such as extrusion molding or the like. The resin layer (A) may be laminated on one surface of the base film by the laminating method such as an extrusion-laminating method, a dry laminating method and the like.

When materials for the sheet according to the present invention are designed, the elastic modulus displacement of the resin layer (A) at the time of heating has been mostly paid attention. Since the set temperature of an attaching machine of a semiconductor wafer surface protection sheet is generally about 60°C as its upper limit, in the design of the sheet, the elastic modular ratio G' (60) / G' (25) has been tested for its optimization where G' (25) is the storage elastic modulus at a room temperature (25°C), and G' (60) is the storage elastic modulus at 60°C. As a result, with respect to the wafer surface having an unevenness of 250 µm, when the elastic modular ratio G' (60) / G' (25) is less than 0.1, if the sheet is attached at a temperature range of 40°C to 70°C and at a pressure range of 0.3 MPa to 0.5 MPa and used, it has been found that very high adhesion to the wafer could be obtained at a normal temperature. This is considered possible because the deformation of the resin layer (A) due to heating and pressurizing effect can sufficiently follow the unevenness on the wafer surface. It is preferable that a resin forming the resin layer (A) exhibiting the aforementioned characteristics contains an olefin copolymer as a main component and an ethylene-α-olefin copolymer such as TAFMER (registered trademark) manufactured by Mitsui Chemicals, Inc can be cited. The olefin copolymer has a property that a corrosive ion or a metallic ion can hardly entrain. Such ions can be a deterioration factor for the circuit on the semiconductor wafer. So, such a copolymer is suitable for the semiconductor wafer surface protection sheet of the present invention because it is a material with less stresses on the environment. Incidentally, the olefin copolymer forming the resin layer (A) of the present invention contains preferably an α-olefin copolymer having at least two kinds of α-olefins selected from α-olefins having 2 to carbon atoms as main unit components from the fact that it exhibits adhesion and low contamination to the semiconductor wafer with solder bumps having uneven shape of big step difference formed thereon. Incidentally, in the present invention, ethylene is considered as one of α-olefins.

As the α-olefin having 2 to 12 carbon atoms, there can be exemplified, for example, ethylene, propylene, 1-butene, 1-pentene, 3-methyl-1-butene, 1-hexene, 4-methyl-1-pentene, 3-mehyl-1-pentene, 1-heptene, 1-octene, 1-decene, 1-dodecene and the like. As the combination excellent in an aptitude for attaching, there can be exemplified, for example, an ethylene-propylene copolymer, an ethylene-1-butene copolymer, a terpolymer of propylene-1-butene-α-olefin having 5 to 12 carbon atoms, a terpolymer of ethylene-propylene-α-olefin having 4 to 12 carbon atoms, a terpolymer having three components of propylene-1-butene-α-olefin having 5 to 12 carbon atoms and the like. Furthermore, the above olefin copolymer can be used singly or in combination of two or more kinds.

It is preferable that the resin layer (A) contains the aforementioned olefin copolymer as a main component. The content thereof is usually from about 60 weight % to 100 weight % and preferably from about 70 weight % to 100 weight %.

The resin forming the resin layer (A) can contain components such as a thermoplastic elastomer, a co-oligomer of ethylene and α-olefin, a synthetic resin and the like as a sub-component, in addition to the olefin copolymer in the ranges in which the object of the present invention is not damaged. By these components, the softening temperature at a temperature of from 40°C to 70° for attaching and the adhesive aptitude at a temperature under the user's environment can be adjusted. As the thermoplastic elastomer, there can be exemplified, for example, a polystyrene elastomer, a polyolefin elastomer, a polyurethane elastomer, a polyester elastomer and the like. In particular, in order to improve the flexibility or adhesion while maintaining the moisture content and ion content at a low level, preferable are a polystyrene elastomer and a polyolefin elastomer. As the polystyrene elastomer, there can be exemplified, for example, a styrene-isoprene-styrene block copolymer (SIS), a styrene-ethylene-butylene-styrene block copolymer (SEBS), a styrene-ethylene-propylene-styrene block copolymer (SEPS), other styrene-diene block copolymer, hydrogenated products thereof and the like. Concrete examples of the SIS include commercial products such as product name: JSR SIS (registered trademark) manufactured by JSR Corporation or product name: KRATON D (registered trademark) manufactured by Shell Kagaku K.K. Further, concrete examples of SEPS include commercial products such as product name: SEPTON (registered trademark) manufactured by Kuraray Co., Ltd. and the like.

As the polyolefin elastomer, a block copolymer of a polyolefin block forming a highly crystalline polymer such as polypropylene comprising a hard part and a monomer copolymer block exhibiting non-crystallinity comprising a soft part can be cited. Concrete examples thereof include an olefin (crystalline)-ethylene-butylene-olefin (crystalline) block copolymer, a polypropylene-polyethyleneoxide-polypropylene block copolymer, a polypropylene-polyolefin (non-crystalline)-polypropylene block copolymer and the like. Concrete examples include commercial products such as product name: DYNARON (registered trademark) manufactured by JSR Corporation and the like.

The co-oligomer of ethylene and α-olefin is usually liquid at a normal temperature. As α-olefin, there can be exemplified, for example, α-olefins having 3 to 20 carbon atoms such as propylene, 1-butene, 1-pentene, 1-hexene, 1-octene, 1-decene, 1-dodecene, 1-tetradecene, 1-hexadecene, 1-octadecene, 4-methyl-1-pentene and the like. Among these, preferable is α-olefin having 3 to 14 carbon atoms. Concrete examples thereof include commercial products such as product name: LUCANT (registered trademark), Hi-wax (registered trademark) and EXCEREX (registered trademark), manufactured by Mitsui Chemicals, Inc.

Further, the synthetic resin is preferably easily made into an alloy with an olefin copolymer having non-halogen as a main component. Concrete examples include a low density polyethylene, a straight chained low density polyethylene, a homopolymer of α-olefin having 3 to 20 carbon atoms, a vinyl acetate resin and the like.

Meanwhile, the resin forming the resin layer (A) used in the present invention may contain a variety of additives which are generally added to this kind of resin in the ranges in which characteristics such as easy adhesion, easy peeling properties, non-contamination with respect to the semiconductor wafer are not impaired. As the additive, there can be exemplified, for example, a variety of ultraviolet light absorbents, antioxidants, heat-resistant stabilizers, lubricants, softening agents, adhesion-imparting agents and the like. As the additive preferably used for the resin layer (A), it is preferable that the type is selected and the amount of combination is also the minimum so as not to exert bad influence on the semiconductor wafer.

When the resin layer (A) is made of two or more layers, resin layers (A) having an elastic modulus and a thickness which do not impair absorption of solder bumps or the like are preferably used in combination. Further, when the sheet is peeled away, tackiness between layers needs to be controlled lest that an interface between the resin layers (A) be peeled away.

The thickness of the resin layer (A) for absorbing (adhering) high step difference formed on the semiconductor wafer surface depends mostly on the step difference such as solder bumps formed on the semiconductor wafer surface. The thickness of the resin layer (A) is preferably not smaller than the step difference formed on the semiconductor wafer surface. For example, in case the step difference has a thickness of 100 µm, the thickness of the resin layer (A) should not be less than 100 µm. When the step difference is 200 µm, the thickness of the resin layer (A) should not less than 200 µm. However, adhesion to the semiconductor wafer having high step difference is greatly influenced by not only the step difference such as solder bumps formed on the semiconductor wafer surface, but also by the shape or placement thereof. So, the thickness of the resin layer (A) suitable for the semiconductor wafer needs to be suitably designed.

As the base film forming the resin layer (A), there can be exemplified, for example, a polyolefin layer, a polyester layer or a laminate of a polyolefin layer and a polyester layer, and the like, which can be properly used according to the production process of the semiconductor wafer. For example, in case of a laminate type made of polyester layer and polyolefin layer, in a grinding processing of the semiconductor wafer, there may be concerns such that the semiconductor wafer might be warped due to the degree of crystallinity of the semiconductor wafer itself or shrinkage of the polyimide film, bump stress or the like. So, by taking a balance between the thickness and rigidity of polyester layer and polyolefin layer, the amount of warpage in the semiconductor wafer can be reduced.

As the base film, preferable are polyolefin such as polyethylene, an ethylene-vinyl acetate copolymer, an ethylene-alkyl acrylate copolymer (an alkyl group having 1 to 4 carbon atoms), an ethylene-α-olefin copolymer, a propylene-α-olefin copolymer, a polypropylene and the like, and polyester such as polyethyleneterephthalate, polyethylenenaphthalate and the like.

Since the configuration of the base film and its thickness depend on the production process of the semiconductor wafer in many cases, the base film needs to be designed in consideration of a method for protecting a semiconductor wafer. For example, to configure the protection sheet, there are four patterns including 1) polyolefin layer / resin layer (A), 2) polyester layer / resin layer (A), 3) polyester layer / polyolefin layer / resin layer (A) and 4) polyolefin layer / polyester layer / resin layer (A). When a grinding process of the semiconductor wafer back surface in the second step is considered to be introduced into a grinding machine, the thickness of the sheets described in items 1) to 4) is preferably not more than 1,000 µm and more preferably not more than 700 µm. In the method for protecting the semiconductor wafer using the sheet, the thickness of the polyester layer is from 5 µm to 100 µm and more preferably from 20 µm to 100 µm in consideration of the workability in the process for producing the semiconductor wafer comprising attaching and peeling of the sheet without damaging adhesion of the resin layer (A). The thickness of the polyolefin layer is from 10 µm to 400 µm and more preferably from 30 µm to 300 µm.

When an etching process using chemicals or the like, or a heat-resistant process is employed in the second and third steps, as the optimum sheet configuration, the sheet configuration in items 2) and 3) having a polyester film laminated at its outermost layer having the chemical resistance and heat resistance is preferable.

The method for producing the semiconductor wafer using the semiconductor wafer surface protection sheet according to the present invention comprises, for example, a first step of adhering the above semiconductor wafer surface protection sheet to the semiconductor wafer surface preferably via the resin layer (A) while heating and pressurizing, and a second step of grinding the semiconductor wafer back surface and subsequently carrying out an etching process and a polishing process for removing a damaged layer generated by a grinding processing on the semiconductor wafer back surface without peeling the surface protecting film in sequence, and then a third step of carrying out metal sputtering and plating treatment or other heating treatment. The step thereafter is not particularly restricted. But, a further example include a method for producing the semiconductor wafer comprising a step of peeling the semiconductor wafer surface protection sheet, a step of dicing for dividing and cutting the semiconductor wafer, a step of molding for sealing the semiconductor chip with a resin for protecting the outer portion, and the like in sequence.

In consideration of adhesion of the resin layer (A) to the semiconductor wafer surface having high step difference in attaching of the first step, as the temperature and pressure conditions, the temperature is preferably in the range of 40°C to 70°C and the pressure is preferably in the range of from 0.3 MPa to 0.5 MPa. This is the condition for making good use of characteristics of the resin layer (A) to the maximum. The resin layer (A) has the relationship of G' (60) / G' (25) < 0.1 where G' (60) is the storage elastic modulus at 60°C and G' (25) is the storage elastic modulus at 25°C. When the temperature is not more than 40°C, the elastic modulus of the resin layer (A) is high, without exhibiting a capability for absorbing step difference, there may be caused some defects in the semiconductor wafer such as voids in some cases. Meanwhile, when the temperature is not less than 70°C, the elastic modulus of the resin layer (A) may become extremely low so that there may arise concerns regarding protrusion of the resin layer (A), thickness non-uniformity of the sheet or the like. When the pressure is not more than 0.3 MPa, step difference can not be fully absorbed. On the contrary, when the pressure is not less than 0.5 MPa, concerns arise regarding protrusion of the resin layer (A), thickness non-uniformity of the sheet or the like. Accordingly, an optimum combination is preferably selected from the temperature range of 40°C to 70°C and the pressure range of 0.3 MPa to 0.5 MPa according to the thickness of the resin layer (A), the shape and placement of step difference on the semiconductor wafer of the side where the sheet is attached, or the like. For example, temperature and pressure conditions of 45°C / 0.35 MPa or 50°C / 0.4 MPa can be cited.

As a method for removing a damaged layer and grinding in the second step, there can be exemplified, for example, a wet etching method using a mixed acid or the like, a plasma etching method, a polishing method or the like. Such methods can be used only for a mechanical grinding mainly by a grindstone in the second step. However, when the semiconductor wafer is further thinned or strength of the chip is desired to be maintained, a step of removing a damaged layer generated on the wafer back surface due to etching or polishing is preferably used in combination thereof.

Then, a step of processing the back surface of the semiconductor wafer (third step) follows. For processing in the third step, without peeling the protecting film, a step of processing under heating conditions for sputtering a metal onto the back surface of the semiconductor wafer or immersing the semiconductor wafer in a plating solution for plating the semiconductor wafer back surface is carried out in some cases. Then, the semiconductor wafer surface protection sheet is peeled away. Furthermore, after the protection sheet is peeled away, treatment such as water washing, plasma washing or the like is applied to the surface of the semiconductor wafer as required.

The thickness of the semiconductor wafer before processing is properly determined depending on the diameter, the type or the like of the semiconductor wafer, and the thickness of the semiconductor wafer after processing the back surface of the semiconductor wafer is properly determined depending on the size of a obtained chip, the type of the circuit or the like.

The operation of attaching the semiconductor wafer surface protection sheet to the surface of the semiconductor wafer is generally conducted by a device denominated as an automatic adhering machine comprising a roll-shaped semiconductor wafer surface protection sheet, though it may be manually operated in some cases. Examples of the automatic adhering machine include Model: ATM-1000B, ATM-1100 and TEAM-100 manufactured by Takatori Corp., Model: 8500 series manufactured by Nitto Seiki Co., Ltd. and the like.

As a method of mechanically grinding the back surface of the semiconductor wafer, known grinding methods such as a through-feed method, an in-feed method and the like are employed. In any of these methods, the back surface grinding is usually conducted while cooling the semiconductor wafer and the grindstone by feeding water thereto.

### EXAMPLES

The present invention is now more specifically illustrated below with reference to Examples. The present invention is not limited to these Examples. Meanwhile, various properties described in Examples were measured by the following methods.

### 1. Measurement of Various Properties

### 1-1. Measurement of Storage Elastic Modulus G'

A sample for measuring a viscoelasticity having a radius of about 8 mm and a thickness of 1 mm is prepared with a resin forming a resin layer (A). A storage elastic modulus G' is measured at from 25°C to 90°C (at which temperature the measurement of elastic modulus of a resin layer becomes impossible) using a dynamic viscoelasticity measuring device (Model: RMS-800, manufactured by Rheometrics Inc.). A measurement frequency is 1 Hz, and a warpage is from 0.1% to 3%.

### 1-2. Density (kg/m³)

The density is measured in accordance with ASTM D 1505.

### 1-3. Breakage of Semiconductor Wafers (Number of Sheets)

With regard to 5 sheets of semiconductor wafers with solder bumps having a radius of 250 µm formed thereon, the wafer back surface is ground to a thickness of a silicon part of 300 µm and then observed to check errors such as dimple or crack using an optical microscope.

### 2. Examples

### 2-1. Example 1

An ethylene - α-olefin copolymer (TAFMER (registered trademark), a product of Mitsui Chemicals, Inc.) having an elastic modulus at 25°C, G' (25), of 5.15 x 10⁶ Pa, an elastic modulus at 60°C, G' (60), of 1.4 x 10⁵ Pa, G'(60) / G' (25) = 0.027 and a density of 810 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) different from the resin layer (A) to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300 m. The protection sheet was peeled away at 25°C and the semiconductor wafer was observed to check bad appearance such as crack or dimple using an optical microscope. The results thereof are illustrated in Table 1. In Table 1, adhesion on the bump was determined acceptable when no voids were formed at the circumference of the bump at the time of attaching. Grindability was determined acceptable when TTV (Total Thickness Variation) inside the wafer after grinding is not more than 20 µm, while unacceptable when TTV is more than 20 µm.

### 2-2. Example 2

An ethylene - α-olefin copolymer (TAFMER (registered trademark), a product of Mitsui Chemicals, Inc.) having an elastic modulus at 25°C, G' (25), of 5.50 x 10⁶ Pa, an elastic modulus at 60°C, G' (60), of 0.18 x 10⁶ Pa, G'(60) / G' (25) = 0.033 and a density of 880 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) different from the resin layer (A) to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 1.

### 2-3. Example 3

An ethylene - α-olefin copolymer (TAFMER (registered trademark), a product of Mitsui Chemicals, Inc.) having an elastic modulus at 25°C, G' (25), of 5.45 x 10⁶ Pa, an elastic modulus at 60°C, G' (60), of 0.16 x 10⁶ Pa, G'(60) / G' (25) = 0.029 and a density of 860 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) different from the resin layer (A) to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 40°C and 0.5 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 1.

### 2-4. Example 4

An ethylene - α-olefin copolymer (TAFMER (registered trademark), a product of Mitsui Chemicals, Inc.) having an elastic modulus at 25°C, G' (25), of 5.45 x 10⁶ Pa, an elastic modulus at 60°C, G' (60), of 0.16 x 10⁶ Pa, G'(60) / G' (25) = 0.029 and a density of 860 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) different from a plastic resin layer to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 70°C and 0.3 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 1.

### 2-5. Example 5

An ethylene - α-olefin copolymer (TAFMER (registered trademark), a product of Mitsui Chemicals, Inc.) having an elastic modulus at 25°C, G' (25), of 5.35 x 10⁶ Pa, an elastic modulus at 60°C, G' (60), of 0.53 x 10⁶ Pa, G'(60) / G' (25) = 0.099 and a density of 890 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm a product of Teijin Dupont Films Ltd.) and a polyolefin layer (EVA, thickness: 120 µm, a product of Dupont-Mitsui Polychemicals Co., Ltd.) different from the resin layer (A) to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 1.

### 2-6. Example 6

An ethylene - α-olefin copolymer (TAFMER (registered trademark), a product of Mitsui Chemicals, Inc.) having an elastic modulus at 25°C, G' (25), of 5.05 x 10⁶ Pa, an elastic modulus at 60°C, G' (60), of 0.22 x 10⁶ Pa, G'(60) / G' (25) = 0.044 and a density of 790 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) having different compositions from the resin to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 1.

### 2-7. Example 7

An ethylene - α-olefin copolymer (TAFMER (registered trademark), a product of Mitsui Chemicals, Inc.) having an elastic modulus at 25°C, G' (25), of 6.15 x 10⁶ Pa, an elastic modulus at 60°C, G' (60), of 0.43 x 10⁶ Pa, G'(60) / G' (25) = 0.070 and a density of 900 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) having different compositions from the resin to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 1.

### 2-8. Example 8

An ethylene - α-olefin copolymer (TAFMER (registered trademark), a product of Mitsui Chemicals, Inc.) having an elastic modulus at 25°C, G' (25), of 5.15 x 10⁶ Pa, an elastic modulus at 60°C, G' (60), of 1.4 x 10⁵ Pa, G' (60) / G' (25) = 0.027 and a density of 810 kg/m³ was used as a resin of a resin layer (A). The ethylene - α-olefin copolymer was subjected to film-making processing at a thickness of 350 µm on the surface of a polyester layer (TEFLEX, thickness: 50 µm, a product of Teijin Dupont Films Ltd.) to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300. µm. The protection sheet was peeled away at 25°C and the semiconductor wafer was observed to check bad appearance such as crack or dimple using an optical microscope. The results thereof are illustrated in Table 1.

### 3-1. Comparative Example 1

Polyolefin (ethylene - vinyl acetate (hereinafter referred to as EVA), a product of Dupont-Mitsui Polychemicals Co., Ltd.) having an elastic modulus at 25°C, G' (25), of 4.30 x 10⁷ Pa, an elastic modulus at 60°C, G' (60), of 1.18 x 10⁷ Pa, G'(60) / G' (25) = 0.27 and a density of 880 kg/m³ was used as a resin having a plasticity. The EVA was subjected to film-making processing at a thickness of 350 µm on a polyester layer (TEFLEX, thickness: 50 µm, a product of Teijin Dupont Films Ltd.) to prepare a semiconductor wafer surface protection sheet. Then, the semiconductor wafer surface protection sheet was attached to the semiconductor wafer with solder bumps having a radius of 250 µm formed thereon via the resin layer having a plasticity under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 2.

### 3-2. Comparative Example 2

Polyolefin (EVA, a product of Dupont-Mitsui Polychemicals Co., Ltd.) having an elastic modulus at 25°C, G' (25), of 4.40 x 10⁷ Pa, an elastic modulus at 60°C, G' (60), of 0.48 x 10⁷ Pa, G'(60) / G' (25) = 0.11 and a density of 840 kg/m³ was used as a resin having a plasticity. The polyolefin was subjected to film-making processing at a thickness of 350 µm on a polyester layer (TEFLEX, thickness: 50 µm, a product of Teijin Dupont Films Ltd.) to prepare a semiconductor wafer surface protection sheet. Then, the semiconductor wafer surface protection sheet was attached to the semiconductor wafer with solder bumps having a radius of 250 µm formed thereon via the resin layer having a plasticity under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 2.

### 3-3. Comparative Example 3

An ethylene - α-olefin copolymer (TAFMER (registered trademark), a product of Mitsui Chemicals, Inc.) having an elastic modulus at 25°C, G' (25), of 5.35 x 10⁶ Pa, an elastic modulus at 60°C, G' (60), of 0.19 x 10⁶ Pa, G'(60) / G' (25) = 0.036 and a density of 850 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) having different compositions from the resin having a plasticity to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 30°C and 0.5 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 2.

### 3-4. Comparative Example 4

An ethylene - α-olefin copolymer (TAFMER (registered trademark), a product of Mitsui Chemicals, Inc.) having an elastic modulus at 25°C, G' (25), of 5.35 x 10⁶ Pa, an elastic modulus at 60°C, G' (60), of 0.19 x 10⁶ Pa, G'(60) / G' (25) = 0.036 and a density of 850 kg/m³ was used as a resin of a resin layer (A). The ethylene - α-olefin copolymer was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) different from the resin layer (A) to prepare a semiconductor wafer surface protection sheet. Then, the semiconductor wafer surface protection sheet was attached to the semiconductor wafer with solder bumps having a radius of 250 µm formed thereon via the resin layer having a plasticity under temperature and pressure conditions of 80°C and 0.2 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 2.

### 3-5. Comparative Example 5

A polyolefin layer (EVA, a product of Dupont-Mitsui Polychemicals Co., Ltd.) having an elastic modulus at 25°C, G' (25), of 4.30 x 10⁷ Pa, an elastic modulus at 60°C, G' (60), of 1.18 x 10⁷ Pa, G'(60) / G' (25) = 0.27 and a density of 880 kg/m³ was used as a resin having a plasticity. The resin having a plasticity was subjected to film-making processing at a thickness of 350 µm on the surface of the polyolefin layer side of a laminated base film made of a polyester layer (TEFLEX, thickness: 50 µm, a product of Teijin Dupont Films Ltd.) and a polyolefin layer (EVA, thickness: 120 µm, a product of Dupont-Mitsui Polychemicals Co., Ltd.) different from the resin having a plasticity to prepare a semiconductor wafer surface protection sheet. Then, the semiconductor wafer surface protection sheet was attached to the semiconductor wafer with solder bumps having a radius of 250 µm formed thereon via the resin layer (A) under temperature and pressure conditions of 60°C and 0.4 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 2.

### 3-6. Comparative Example 6

A polyolefin layer (EVA, a product of Dupont-Mitsui Polychemicals Co., Ltd.) having an elastic modulus at 25°C, G' (25), of 4.30 x 10⁷ Pa, an elastic modulus at 60°C, G' (60), of 1.18 x 10⁷ Pa, G'(60) / G' (25) = 0.27 and a density of 880 kg/m³ was used as a resin having a plasticity. The EVA was subjected to film-making processing at a thickness of 350 µm on a polyester layer (TEFLEX, thickness: 50 µm, a product of Teijin Dupont Films Ltd.) to prepare a semiconductor wafer surface protection sheet. Then, the semiconductor wafer surface protection sheet was attached to the semiconductor wafer with solder bumps having a radius of 250 µm formed thereon via the resin layer having a plasticity under temperature and pressure conditions of 30°C and 0.2 MPa, and the resulting material was ground to a thickness of the silicon part of 300 µm. The protection sheet was peeled away at 25°C and the semiconductor wafer was observed to check bad appearance such as crack or dimple using an optical microscope. The results thereof are illustrated in Table 2.

### INDUSTRIAL APPLICABILITY

The present invention can be used for producing and processing a semiconductor wafer suitable for high-density mounting.

**Table 1]**

| | Example 1 | Example 2 | Example 3 | Example 4 | Example 5 | Example 6 | Example 7 | Example 8 |
|---|---|---|---|---|---|---|---|---|
| Brand | Ethylene-α-olefin | Ethylene-α-olefin | Ethylene-α-olefin | Ethylene-α-olefin | Ethylene-α-olefin | Ethylene-α-olefin | Ethylene-α-olefin | Ethylene-α-olefin |
| G' (25) (Pa) | 3.13 x 10⁶ | 3.30 x 10⁶ | 5.45 x 10⁶ | 4 x 10⁶ | 5.35 x 10⁶ | 5.05x10⁶ | 6.15 x 10⁶ | 5.15 x 10⁶ |
| G' (60) (Pa) | 0.10. x 10⁶ | 0.18 x 10⁶ | 0.16 x 10⁶ | 0.16 x 10⁶ | 0.33 x 10⁶ | 0.22 x 10⁶ | 0.43 x 10⁶ | 0.14 x 10⁶ |
| G'(60) / G'(25) | 0.027 | 0.033 | 0.029 | 0.029 | 0.099 | 0.044 | 0.070 | 0.027 |
| Density (kg/m³) | 810 | 880 | 860 | 860 | 890 | 790 | 900 | 810 |
| Thickness (µm) | 350 | 350 | 350 | 350 | 350 | 350 | 350 | 350 |
| Attaching temperature | 60 | 60 | 40 | 70 | 60 | 60 | 60 | 60 |
| Attaching pressure (MPa) | 0-4 | 0.4 | 0.5 | 0.3 | 0.4 | 0.4 | 0.4 | 0.4 |
| Adhesion on bump (existence of void) | | | | | | | | |
| Grindability (wafer TTV after grinding) | | | | | | | | |
| Wafer dimple | | | | | | | | |
| Edge crack | | | | | | | | |

**[Table 2]**

| | Comparative Example 1 | Comparative Example 2 | Comparative Example 3 | Comparative Example 4 | Comparative Example 5 | Comparative Example 6 |
|---|---|---|---|---|---|---|
| Brand | Ethylene-vinyl acetate | Ethylene-vinyl acetate | Ethylene-α-olefin | Ethylene-α-olefin | Ethylene-vinyl acetate | Ethylene-vinyl acetate |
| G' (25) (Pa) | 4.30 x 10⁷ | 4.40 x 10⁷ | 5.35 x 10⁶ | 5.35 x 10⁶ | 4.30 x 10⁷ | 4.30 x 10⁷ |
| G' (60) (Pa) | 1.18 x 10⁷ | 0.48 x 10⁷ | 0.19 x 10⁶ | 0.19 x 10⁶ | 1.18 x 10⁷ | 1.18 x 10⁷ |
| G' (60) / G' (25) | 0.27 | 0.11 | 0.036 | 0.036 | 0.27 | 0.27 |
| Density (kg/m³) | 880 | 840 | 850 | 850 | 880 | 880 |
| Thickness (µm) | 350 | 350 | 350 | 350 | 350 | 350 |
| Attaching temperature (°C) | 60 | 60 | 30 | 80 | 60 | 30 |
| Attaching pressure (MPa) | 0.4 | 0.4 | 0.5 | 0.2 | 0.4 | 0.2 |
| Adhesion on bump (existence of void) | unacceptable | acceptable | unacceptable | unacceptable | unacceptable | unacceptable |
| Grindability (wafer TTV after grinding) | unacceptable | acceptable | unacceptable | unacceptable | unacceptable | unacceptable |
| Wafer dimple | 4 | 1 | 3 | 4 | 2 | 5 |
| Edge crack | 5 | 1 | 4 | 3 | 3 | 5 |

## Claims

1. A sheet suitable for protecting a semiconductor wafer surface, which comprises at least a resin layer (A) satisfying the relationships of
(i) G' (60) / G' (25)< 0.1, and **characterized by**
(ii) 0.05 x 10⁶ Pa ≤ G'(60) ≤ 1.0 x 10⁶ Pa,
wherein G'(25) and G' (60) represent the storage elastic modulus at 25°C and 60°Crespectively.

2. The sheet of claim 1, wherein the density of the resin layer (A) is 800-890 kg/m³.

3. The sheet of claim 1, wherein the resin layer (A) comprises an olefin copolymer.

4. The sheet of claim 3, wherein the olefin copolymer comprises an α-olefin copolymer containing at least two kinds of C₂₋₁₂-(α-olefins) as main unit components.

5. The sheet of claim 1, wherein the resin layer (A) comprises a laminate having two or more layers made of different resins.

6. The sheet of claim 1, wherein the thickness of the resin layer (A) is not smaller than a step difference formed on a surface of a semiconductor wafer.

7. The sheet of claim 1, wherein a film of the resin layer (A) is laminated on a base film.

8. The sheet of claim 7, wherein the resin layer (A) is laminated on only one surface of the base film.

9. The sheet of claim 7, wherein the base film is a polyolefin layer, a polyester layer or a laminate of both.

10. The sheet of claim 1, the layer configuration of which is polyolefin/resin (A), polyester/resin (A), polyester/ polyolefin/resin (A) or polyolefin/polyester/resin (A).

11. A method for protecting a semiconductor wafer comprising the steps of:
(i) adhering the sheet of claim 1 to a circuit-formed surface of a semiconductor wafer under a pressure of 0.3-0.5 MPa and at a temperature of 40-70°C;
(ii) grinding the non-circuit-formed surface of the semiconductor wafer; and
(iii)processing the non-circuit-formed surface of the semiconductor wafer after grinding.

12. The method of claim 11, wherein step (ii) comprises at least one of mechanical grinding by a grindstone, wet etching, plasma etching and polishing.

13. The method of claim 11, wherein step (iii) comprises at least one of metal sputtering, plating and heating.

## Patentansprüche

1. Blatt, das zum Schutz einer Halbleiter-Wafer-Oberfläche geeignet ist, und das mindestens eine Harzschicht (A) umfasst, die den folgenden Beziehungen genügt
(i) G'(60)/G'(25) < 0,1 und **dadurch gekennzeichnet, dass**
(ii) 0,05 x 10⁶ Pa ≤ G'(60) ≤ 1,0 x 10⁶ Pa,
worin G'(25) und G'(60) jeweils das Lager-Elastizitätsmodul bei 25°C bzw. 60°C ist.

2. Blatt gemäß Anspruch 1, worin die Dichte der Harzschicht (A) 800 bis 890 kg/m³ ist.

3. Blatt gemäß Anspruch 1, worin die Harzschicht (A) ein Olefincopolymer umfasst.

4. Blatt gemäß Anspruch 3, worin das Olefincopolymer ein α-Olefincopolymer umfasst, das mindestens zwei Arten von C₂₋₁₂-(α-Olefinen) als Haupteinheitskomponenten enthält.

5. Blatt gemäß Anspruch 1, worin die Harzschicht (A) ein Laminat umfasst, das zwei oder mehr Schichten aus unterschiedlichen Harzen aufweist.

6. Blatt gemäß Anspruch 1, worin die Dicke der Harzschicht (A) nicht geringer ist als ein auf einer Halbleiter-Wafer-Oberfläche gebildete Stufendifferenz.

7. Blatt gemäß Anspruch 1, worin ein Film der Harzschicht (A) auf einen Basisfilm laminiert ist.

8. Blatt gemäß Anspruch 7, worin die Harzschicht (A) lediglich auf eine Oberfläche des Basisfilms laminiert ist.

9. Blatt gemäß Anspruch 7, worin der Basisfilm eine Polyolefinschicht, eine Polyesterschicht oder ein Laminat aus beiden ist.

10. Blatt gemäß Anspruch 1, in dem die Schichtkonfiguration Polyolefin/Harz (A), Polyester/Harz (A), Polyester/Polyolefin/Harz (A) oder Polyolefin/Polyester/Harz (A) ist.

11. Verfahren zur Herstellung eines Halbleiter-Wafers, das folgende Schritte umfasst:
(i) Haften des Blattes gemäß Anspruch 1 an eine Schaltkreis-bildende Oberfläche eines Halbleiter-Wafers unter einem Druck von 0,3 bis 0,5 MPa und einer Temperatur von 40 bis 70°C;
(ii) Schleifen der Nicht-Halbleiter-bildenden Oberfläche des Halbleiter-Wafers; und
(iii) Prozessieren der Nicht-Halbleiter-bildenden Oberfläche des Halbleiter-Wafers nach dem Schleifen.

12. Verfahren gemäß Anspruch 11, wobei Schritt (ii) mindestens eines aus mechanischem Schleifen durch einen Schleifstein, Nassätzen, Plasmaätzen und Polieren umfasst.

13. Verfahren gemäß Anspruch 11, wobei Schritt (iii) mindestens eines aus Metallsputtern, Plattieren und Heizen umfasst.

## Revendications

1. Feuille adaptée pour protéger une surface d'une plaquette semi-conductrice, qui comprend au moins une couche de résine (A) satisfaisant les relations
(i) G' (60) /G' (25) < 0,1, et **caractérisée par**
(ii) 0,05 x 10⁶ Pa ≤ G' (60) ≤ 1,0 x 10⁶ Pa,
où G'(25) et G'(60) représentent le module d'élasticité au stockage à 25 °C et à 60°C, respectivement.

2. Feuille de la revendication 1, dans laquelle la densité de la couche de résine (A) est de 800-890 kg/m³.

3. Feuille de la revendication 1, dans laquelle la couche de résine (A) comprend un copolymère oléfinique.

4. Feuille de la revendication 3, dans laquelle le copolymère oléfinique comprend un copolymère α-oléfinique contenant au moins deux types d'α-oléfines en C₂-C₁₂ en tant que composants unitaires principaux.

5. Feuille de la revendication 1, dans laquelle la couche de résine (A) comprend un stratifié ayant deux couches ou plus réalisées avec résines différentes.

6. Feuille de la revendication 1, dans laquelle l'épaisseur de la couche de résine (A) n'est pas inférieure à une différence de pas formée sur une surface d'une plaquette semi-conductrice.

7. Feuille de la revendication 1, dans laquelle un film de la couche de résine (A) est stratifié sur un film de base.

8. Feuille de la revendication 7, dans laquelle la couche de résine (A) est stratifiée sur une seule surface du film de base.

9. Feuille de la revendication 7, dans laquelle le film de base est une couche de polyoléfine, une couche de polyester ou un stratifié des deux.

10. Feuille de la revendication 1, dont la configuration de la couche est polyoléfine/résine (A), polyester/résine (A), polyester/polyoléfine/résine (A) ou polyoléfine/polyester/résine (A).

11. Procédé destiné à protéger une plaquette semi-conductrice comprenant les étapes qui consistent :
(i) à faire adhérer la feuille de la revendication 1 à une surface formée d'un circuit d'une plaquette semi-conductrice sous une pression de 0,3-0,5 MPa et à une température de 40-70 °C ;
(ii) à meuler la surface non formée d'un circuit de la plaquette semi-conductrice ; et
(iii) à traiter la surface non formée d'un circuit de la plaquette semi-conductrice après meulage.

12. Procédé de la revendication 11, dans lequel l'étape (ii) comprend au moins l'un d'un meulage mécanique par une meule, d'une gravure humide, d'une gravure au plasma et d'un polissage.

13. Procédé de la revendication 11, dans lequel l'étape (iii) comprend au moins l'un(e) d'une pulvérisation métallique, d'un placage et d'un chauffage.
